# EUROPEAN PATENT SPECIFICATION

(11) **EP 3 376 658 B1**
(45) Date of publication and mention of the grant of the patent: **02.12.2020**
(21) Application number: 17207714.1
(22) Date of filing: 15.12.2017
(51) Int. Cl.: H02M 7/00, H05K 1/02

(54) **POWER CONVERSION DEVICE AND POWER SUPPLY APPARATUS**
ENERGIEUMWANDLUNGSVORRICHTUNG UND STROMVERSORGUNGSVORRICHTUNG
DISPOSITIF DE CONVERSION DE PUISSANCE ET APPAREIL D'ALIMENTATION ÉLECTRIQUE

(30) Priority: 13.03.2017 JP 2017047399
(43) Date of publication of application: 19.09.2018
(73) Proprietor: OMRON CORPORATION, Kyoto-shi, Kyoto 600-8530 (JP)
(72) Inventor: TANINO, Kohei, Kyoto-shi, Kyoto 600-8530 (JP); NAGANO, Masaaki, Kyoto-shi, Kyoto 600-8530 (JP); TAKATORI, Koji, Kyoto-shi, Kyoto 600-8530 (JP); SHIMIZU, Masato, Kyoto-shi, Kyoto 600-8530 (JP); NIWA, Hiroki, Kyoto-shi, Kyoto 600-8530 (JP); YAMAMOTO, Michihiro, Kyoto-shi, Kyoto 600-8530 (JP); OKADA, Kei, Kyoto-shi, Kyoto 600-8530 (JP)
(74) Representative: Becker & Kurig Partnerschaft Patentanwälte PartmbB

(56) References cited:
- WO-A1-2016/017260
- WO-A1-2016/194050
- WO-A1-2017/002398

## Description

### BACKGROUND

### Technical Field

The present disclosure relates to a power conversion device and a power supply apparatus including a radiator for radiating heat generated from a semiconductor element.

### Description of Related Art

Power conversion devices for controlling an output voltage and the like by switching a semiconductor element which is a switching element are used for various purposes. A power conversion device is equipped with a radiator (heat sink) in order to radiate heat generated from a semiconductor element. For example, a power conversion device disclosed in Patent Document 1 includes a semiconductor element, a printed board on which the semiconductor element is mounted, and a radiator for radiating heat generated from the semiconductor element. In addition, the printed board includes a first printed pattern connected to a terminal having a potential that does not change in a switching operation of the semiconductor element and a second printed pattern connected to a terminal provided at the backside of the printed board and having a potential that changes in a switching operation of the semiconductor element.

### Patent Documents

[Patent Document 1] Japanese Unexamined Patent Application Publication No. 2012-110231

WO 2016/194050 A1 discloses a power conversion device with a power module that is provided between a first power supply busbar that supplies positive power, and a second power supply busbar that supplies negative power; a first capacitor, one end of which is connected to the first power supply busbar; a second capacitor, one end of which is connected to the second power supply busbar; a grounding member that is connected between the other end of the first capacitor and the other end of the second capacitor; and a conductive member, which is disposed along the first power supply busbar and/or the second power supply busbar, and which connects the grounding member and a ground potential to each other.

WO 2017/002398 A1 discloses a power conversion device applicable to a power conversion device including a switching element that is arranged on a line and a radiator that is connected to a predetermined potential such as a ground potential. A noise eliminator in which an electric conductor is covered by an insulator is interposed between a switching element and a radiator, and the electric conductor of the noise eliminator is connected to a stable potential of the line.

WO 2016/017260 A1 discloses a semiconductor module for which noise suppression effect is enhanced by minimizing a noise current loop. A semiconductor module comprises: a circuit block including an AL insulating substrate, circuit patterns formed on one surface of the AL insulating substrate, and power semiconductor chips; and a heat dissipating body formed on the other surface of the AL insulating substrate.

### SUMMARY

However, in a power conversion device, a parasitic capacitance generated between a radiator for radiating heat generated from a semiconductor element and the semiconductor element is large and thus noise caused by the parasitic capacitance is generated and output to an input side of the power conversion device. That is, the power conversion device has a problem that noise is generated due to coupling of a drain terminal of the semiconductor element and the radiator.

In addition, in the power conversion device disclosed in Patent Document 1, a conductor used as a radiator is mounted on the printed board in addition to the first printed pattern and the second printed pattern. Accordingly, it is difficult to reduce the size of the power conversion device disclosed in Patent Document 1.

The present disclosure is directed to provide a power conversion device and a power supply apparatus which can decrease noise and can be reduced in size.

According to an embodiment of the present disclosure, a power conversion device includes: a metal board comprising a circuit part, an insulating layer, and a metal part, wherein the insulating layer is interposed between the circuit part and the metal part; a semiconductor element mounted on the circuit part of the metal board; an insulator; and a radiator with the insulator interposed therebetween, wherein the metal part of the metal board is connected to a stable potential of the semiconductor element.

Preferably, the stable potential of the semiconductor element and the metal part may be connected through a wiring pattern formed on the circuit part.

Preferably, the semiconductor element may be fixed to the metal board through screwing. Preferably, the power conversion device may further include a circuit board connected to the metal board.

Preferably, the circuit board may come into contact with a side surface of the metal board and may be fixed to the metal part using a fixing member.

According to another embodiment of the present disclosure, a power supply apparatus includes the aforementioned power conversion device.

According to the power conversion device according to the present technology, a semiconductor element is mounted on a circuit part of a metal board, a radiator is arranged at a metal part of the metal board having an insulator interposed therebetween, and the metal part of the metal board is connected to a stable potential of the semiconductor element, and thus a noise can be decreased and the size of the power conversion device can be reduced.

### BRIEF DESCRIPTION OF THE DRAWINGS

FIG. 1 is a side view schematically illustrating an example of the exterior of a power conversion device according to embodiments of the present disclosure.
FIG. 2 is a perspective view schematically illustrating an example of the exterior of the power conversion device according to embodiments of the present disclosure.
FIG. 3 is a block diagram for describing a power supply apparatus including the power conversion device according to embodiments of the present disclosure.
FIG. 4 is a circuit diagram of the power conversion device according to embodiments of the present disclosure.

### DESCRIPTION OF THE EMBODIMENTS

Hereinafter, the present embodiment will be described in detail with reference to the attached drawings. Meanwhile, the same reference numerals in the drawings represent the same or similar parts.

### (A. Exterior of power conversion device)

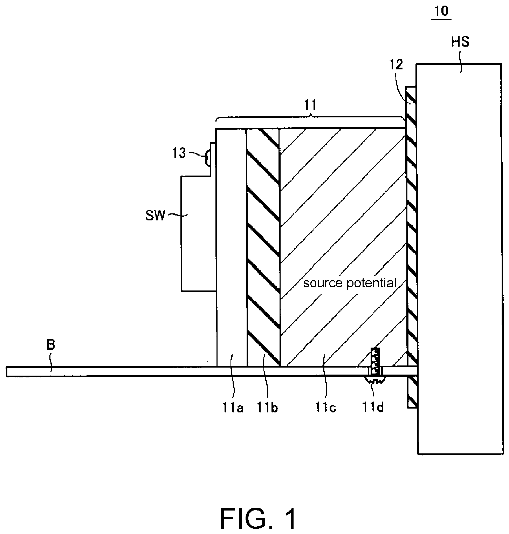

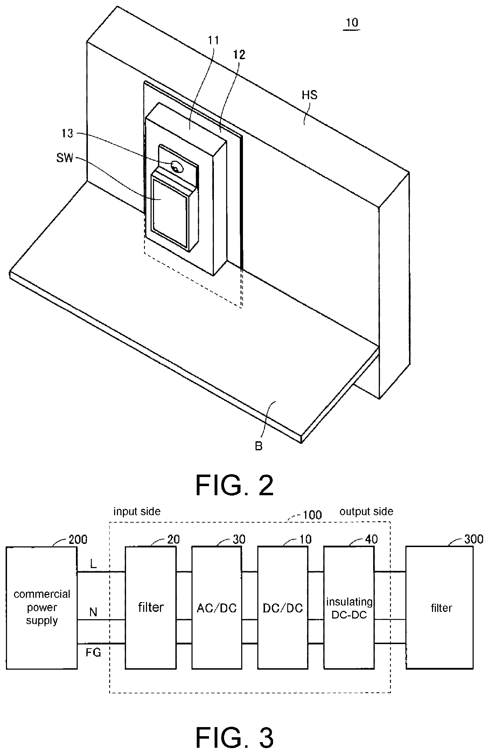

The exterior of a power conversion device according to embodiments of the present disclosure will be described using the drawings. FIG. 1 is a side view schematically illustrating an example of the exterior of the power conversion device according to embodiments of the present disclosure. FIG. 2 is a perspective view schematically illustrating an example of the exterior of the power conversion device according to embodiments of the present disclosure. Meanwhile, the power conversion device illustrated in FIG. 1 is different in scale from the actual scale thereof in the thickness direction of a metal board 11 in order to explain the configuration.

A power conversion device 10 according to embodiments of the present disclosure is a device such as an inverter, a DC-DC converter or the like which performs control related to conversion of an output voltage and/or an output current using a semiconductor element SW which is a switching element.

The semiconductor element SW is configured of a switching element such as a metal-oxide-semiconductor field-effect transistor (MOSFET), an insulated gate bipolar transistor (IGBT), or the like. The semiconductor element SW has a source terminal Ssw, a gate terminal Gsw and a drain terminal Dsw and is mounted on an external circuit of the metal board 11. One side of the metal board 11 is an external circuit 11a (circuit part) and the other side is a base metal 11c (metal part). The metal board 11 has an insulating layer 11b (insulating part) between the external circuit 11a and the base metal 11c. The external circuit 11a includes a wiring pattern for mounting the semiconductor element SW and has a thickness of about 18 to 300 µm.

The base metal 11c is a metal plate formed of aluminum or copper and has a thickness of 0.5 to 30 mm. In addition, the base metal 11c is electrically connected to the source terminal Ssw of the semiconductor element SW through the wiring pattern formed on the external circuit 11a, which is not shown. That is, the potential of the base metal 11c is a stable potential (source potential). The base metal 11c has a screw tap formed thereon and the semiconductor element SW mounted on the external circuit 11a can be fixed using a screw 13.

In addition, the metal board 11 is fixed onto a board B (circuit board). The board B comes into contact with a side surface of the metal board 11 and is fixed to the base metal 11c using a screw 11d (fixing member). The base metal 11c has a screw tap corresponding to the screw 11d. Further, a heat sink (radiator) HS having a function of performing cooling by radiating heat generated from the semiconductor element SW to the outside is mounted on the board B approximately perpendicularly to the upper surface of the board B. The heat sink HS is a part of the power conversion device 10 and is electrically connected to a frame ground (FG) which will be described below.

The heat sink HS is arranged at the side of the base metal 11c of the metal board 11 with an insulator 12 interposed therebetween. Accordingly, the semiconductor element SW radiates generated heat to the metal board 11 and the metal board 11 radiates the heat to the heat sink HS through the insulator 12. The base metal 11c of the metal board 11 is connected to the stable potential of the semiconductor element SW in order to reduce noise current flowing from a parasitic capacitance generated between the semiconductor element SW and the heat sink HS to the input side of the power conversion device 10.

Meanwhile, to improve the efficiency of heat conduction of transferring the heat generated in the semiconductor element SW to the heat sink HS through the metal board 11, the semiconductor element SW has a heat-radiating surface attached to one side of the metal board 11 and the heat sink HS has a heat-absorbing surface attached to the other side of the metal board 11.

### (B. Circuit configuration of power conversion device)

Next, a circuit configuration of the power conversion device 10 according to embodiments of the present disclosure will be described. For example, the power conversion device 10 is used for a power supply apparatus. FIG. 3 is a block diagram for describing a power supply apparatus 100 including the power conversion device 10 according to embodiments of the present disclosure. The power supply apparatus 100 including the power conversion device 10 includes a filter 20, an AC-DC converter 30 (AC/DC), the power conversion device 10 (DC/DC), and an insulating DC-DC converter 40 (insulating DC/DC). In addition, an AC power supply which is a commercial power supply 200 is connected to the filter which is an input side of the power supply apparatus 100 and a power load 300 (load) is connected to the insulating DC-DC converter which is an output side of the power supply apparatus 100. Furthermore, circuits from the AC power supply which is the commercial power supply 200 to the insulating DC-DC converter 40 are arranged in series on wires connected to live L, neutral N and ground FG.

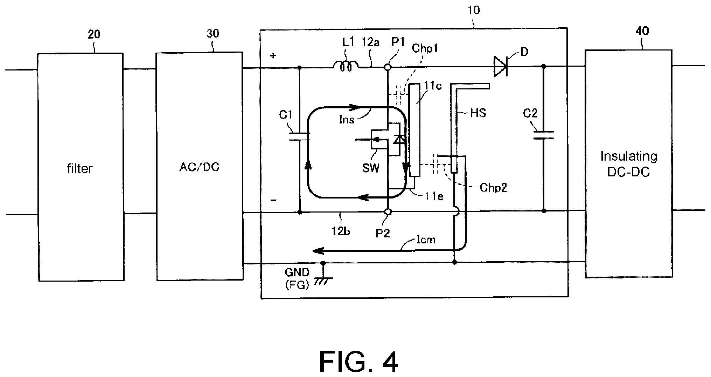

The circuit configuration of the power conversion device 10 will be described in more detail. FIG. 4 is a circuit diagram of the power conversion device according to embodiments of the present disclosure. In a control system illustrated in FIG. 4, the filter 20 connected to the AC power supply (not shown), the AC-DC converter 30 such as a diode bridge which converts an AC supplied from the AC power supply to a DC, the power conversion device 10 which performs power conversion such as voltage smoothing and boosting, and the insulating DC-DC converter 40 such as a transformer which performs conversion to a voltage and a current of standards depending on the power load 300 (not shown) are used. A DC converted from an AC by the AC-DC converter 30 is a pulsating current obtained when the direction of a minus voltage is inverted for an AC output from the filter 20 and has a fixed direction but a varying magnitude. In addition, a DC voltage supplied as a pulsating current is smoothed by the power conversion device 10.

The power conversion device 10 includes a first line 12a and a second line 12b which connect the input side connected to the AC-DC converter 30 and the output side connected to the insulating DC-DC converter 40. The first line 12a and the second line 12b are connected to a first potential and a second potential of the input side. The first line 12a is connected to a plus side, for example, as the first potential. The second line 12b is connected to a minus side, for example, as the second potential and used as a wire connected to a stable potential lower than the first potential.

In the power conversion device 10, a first capacitor C1 which connects the first line 12a and the second line 12b and performs smoothing is arranged at the input side which receives an input from the AC-DC converter 30. In addition, a boosting circuit (boosting chopper) using a reactor L1, the semiconductor element SW, a rectifying element D and a second capacitor C2 is arranged at the output side which performs output to the insulating DC-DC converter 40.

The reactor L1 and the rectifying element D provided as the boosting circuit are connected in series on the first line 12a. The rectifying element D is arranged in such a manner that an anode terminal corresponds to the input side and a cathode terminal corresponds to the output side, and the reactor L1 is serially connected to the anode side. In addition, the second capacitor C2 is arranged at the side of the cathode of the rectifying element D to connect the first line 12a and the second line 12b.

Further, the semiconductor element SW of the boosting circuit is arranged such that the first line 12a and the second line 12b short-circuit. In the circuit illustrated in FIG. 4, a MOSFET including an antiparallel diode is used as the semiconductor element SW. The drain terminal of the semiconductor element SW is connected to a first point P1 of the first line 12a between the reactor L1 and the rectifying element D, and the source terminal is connected to a second point P2 of the second line 12b. Further, the second point P2 is positioned between a connection point at which the first capacitor C1 is connected to the second line 12b and a connection point at which the second capacitor C2 is connected to the second line 12b.

In FIG. 4, the heat sink HS arranged in proximity to the right side of the semiconductor element SW is shown, and the metal board 11 is arranged between the semiconductor element SW and the heat sink HS. The heat sink HS is connected to a frame ground (FG) corresponding to a ground potential. The base metal 11c of the metal board 11 is connected to the second line 12b through a connection line 11e.

When the heat sink HS is connected to the FG, a first parasitic capacitance Chp1 is generated between the semiconductor element SW and the heat sink HS. In addition, a second parasitic capacitance Chp2 is generated between the base metal 11c of the metal board 11 and the heat sink HS.

Due to the first parasitic capacitance Chp1 generated between the base metal 11c of the metal board 11 and the semiconductor element SW, a voltage variation at the first point P1 is transferred from the base metal 11c to the second line 12b through the second point P2 and thus a noise current Ins flows. However, the noise current Ins transferred to the second line 12b flows and circulates through the second point P2, the first capacitor C1, the reactor L1 and the first point P1 and is confined within the circuit composed of such elements and thus is not output as a noise to the input side of the power conversion device 10.

In addition, due to the second parasitic capacitance Chp2 generated between the base metal 11c of the metal board 11 and the heat sink HS, a voltage variation at the second point P2 is transferred from the heat sink HS to the FG and thus a common mode current Icm flows as noise. The common mode current Icm can be represented by a value obtained by multiplying the second parasitic capacitance Chp2 by a temporal change of a voltage V2 of the second point P2. In addition, the voltage V2 of the second point P2 is the potential of the source terminal Ssw of the semiconductor element SW, which is a stable potential, and thus is less than a temporal change of a voltage V1 of the first point P1. Accordingly, the noise of the common mode current Icm caused by the temporal change at the second point P2 is less than the noise of the common mode current Icm caused by the temporal change at the first point PI, and thus the common mode current is so small that it can be ignored even when output to the input side of the power conversion device 10 as noise.

As described above, the power conversion device 10 according to embodiments of the present disclosure includes the metal board 11 of which one side is the external circuit 11a and the other side is the base metal 11c, the semiconductor element SW mounted on the external circuit 11a of the metal board 11, the insulator 12 arranged on the base metal 11c of the metal board 11, and the heat sink HS arranged at the base metal 11c of the metal board 11 having the insulating 12 interposed therebetween. In addition, the base metal 11c of the metal board 11 is connected to the stable potential of the semiconductor element SW. Accordingly, the noise current Ins caused by the first parasitic capacitance Chp1 generated between the base metal 11c of the metal board 11 and the semiconductor element SW can be confined within the power conversion device 10. Furthermore, the base metal 11c is connected to the second line 12b corresponding to the stable potential, and thus the common mode current Icm caused by the second parasitic capacitance Chp2 generated between the base metal 11c of the metal board 11 and the heat sink HS can be suppressed. Moreover, the power conversion device 10 can be configured in such a manner that the semiconductor element SW, the metal board 11, the insulator 12 and the heat sink HS are stacked and thus can be reduced in size.

Further, since the semiconductor element SW is fixed by forming a screw tap at the base metal 11c and using a screw, it is possible to reduce unnecessary structural components.

In addition, the configuration of a conventional circuit board can be used for the board B by connecting the metal board 11 and the board B, and thus a board design can be simplified and manufacturing costs can be reduced.

Moreover, the metal board 11 has the insulating layer 11b between the external circuit 11a and the base metal 11c, and the base metal 11c is connected to the stable potential of the semiconductor element SW through a wiring pattern formed on the external circuit 11a. Accordingly, it is possible to set the potential of the base metal 11c to the stable potential of the semiconductor element SW while securing insulation between the external circuit 11a and the base metal 11c.

Furthermore, the board B comes into contact with a side surface of the metal board 11 and is fixed to the base metal 11c using the screw 11d (fixing member). Accordingly, it is possible to fix the metal board 11 on which the semiconductor element SW is mounted to the board B with stability.

Further, the power supply apparatus 100 including the power conversion device 10 according to embodiments of the present disclosure can decrease noise and can be reduced in size.

In addition, the power conversion device 10 according to embodiments of the present disclosure is not limited to the aforementioned embodiments and can be applied to various devices such as a DC-AC inverter and a DC chopper using a semiconductor switch in technical fields such as power electronics.

### [Reference Signs List]

- 10:: power conversion device
- 11:: metal board
- 11a:: external circuit
- 11b:: insulating layer
- 11c:: base metal
- 12a:: first line
- 12b:: second line
- HS:: heat sink
- SW:: semiconductor element

## Claims

1. A power conversion device (10), comprising:
a metal board (11), comprising a circuit part (11a), an insulating layer (11b), and a metal part (11c);
a semiconductor element (SW) mounted on the circuit part (11a) of the metal board (11) and comprising a Drain terminal, a Source terminal and a Gate terminal;
an insulator (12); and
a radiator (HS), the power conversion device (10) being **characterized in that**
the insulating layer (11b) is interposed between the circuit part (11a) and the metal part (11c),
the insulator (12) is interposed between the radiator (HS) and the metal part (11c) of the metal board (11), and **in that**
the metal part (11c) of the metal board (11) is connected to a stable potential of the semiconductor element (SW), the stable potential being the potential of the Source terminal.

2. The power conversion device (10) according to claim 1, wherein the stable potential of the semiconductor element (SW) and the metal part are connected through a wiring pattern formed on the circuit part.

3. The power conversion device (10) according to claim 1 or 2, wherein the semiconductor element (SW) is fixed to the metal board (11) through screwing.

4. The power conversion device (10) according to any one of claims 1 to 3, further comprising:
a circuit board connected to the metal board (11).

5. The power conversion device (10) according to claim 4, wherein the circuit board comes into contact with a side surface of the metal board (11) and is fixed to the metal part using a fixing member.

6. A power supply apparatus (100), comprising the power conversion device (10) according to any one of claims 1 to 5.

## Patentansprüche

1. Stromumwandlungsvorrichtung (10), umfassend:
eine Metallplatte (11), die einen Schaltungsteil (11a), eine Isolierschicht (11b) und einen Metallteil (11c) umfasst;
ein Halbleiterelement (SW), das auf dem Schaltungsteil (11a) der Metallplatte (11) montiert ist und einen Drain-Anschluss, einen Source-Anschluss und einen Gate-Anschluss umfasst;
einen Isolator (12); und
einen Heizstrahler (HS), wobei die Stromumwandlungsvorrichtung (10) **dadurch gekennzeichnet ist, dass**
die Isolierschicht (11b) zwischen dem Schaltungsteil (11a) und dem Metallteil (11c) zwischenpositioniert ist,
der Isolator (12) zwischen dem Heizstrahler (HS) und dem Metallteil (11c) der Metallplatte (11) zwischenpositioniert ist, und dadurch, dass
das Metallteil (11c) der Metallplatte (11) mit einem stabilen Potential des Halbleiterelements (SW), dem stabilen Potenzial, dass das Potenzial des Source-Anschluss ist, verbunden ist.

2. Stromumwandlungsvorrichtung (10) gemäß Anspruch 1, wobei das stabile Potential des Halbleiterelements (SW) und das Metallteil durch ein Verdrahtungsmuster, das auf dem Schaltungsteil ausgebildet ist, verbunden sind.

3. Stromumwandlungsvorrichtung (10) gemäß Anspruch 1 oder 2, wobei das Halbleiterelement (SW) durch Verschrauben an der Metallplatte (11) befestigt ist.

4. Stromumwandlungsvorrichtung (10) gemäß irgendeinem der Ansprüche 1 bis 3, ferner umfassend:
eine Schaltungsplatte, die mit der Metallplatte (11) verbunden ist.

5. Stromumwandlungsvorrichtung (10) gemäß Anspruch 4, wobei die Schaltungsplatte mit einer Seitenoberfläche der Metallplatte (11) in Kontakt kommt und an dem Metallteil unter Verwendung eines Befestigungselements befestigt ist.

6. Stromversorgungsvorrichtung (100), die die Stromumwandlungsvorrichtung (10) gemäß einem der Ansprüche 1 bis 5 umfasst.

## Revendications

1. Dispositif de conversion d'énergie électrique (10), comprenant :
une carte métallique (11), comprenant une partie de circuit (11a), une couche isolante (11b) et une partie métallique (11c) ;
un élément semi-conducteur (SW) monté sur la partie de circuit (11a) de la carte métallique (11) et comprenant une borne de drain, une borne de source et une borne de grille ;
un isolateur (12) ; et
un radiateur (HS), le dispositif de conversion d'énergie électrique (10) étant **caractérisé en ce que**
la couche isolante (11b) est interposée entre la partie de circuit (11a) et la partie métallique (11c),
l'isolateur (12) est interposé entre le radiateur (HS) et la partie métallique (11c) de la carte métallique (11), et
la partie métallique (11c) de la carte métallique (11) est connectée à un potentiel stable de l'élément semi-conducteur (SW), le potentiel stable étant le potentiel de la borne de source.

2. Dispositif de conversion d'énergie électrique (10) selon la revendication 1, dans lequel le potentiel stable de l'élément semi-conducteur (SW) et la partie métallique sont connectés par un motif de câblage formé sur la partie de circuit.

3. Dispositif de conversion d'énergie électrique (10) selon la revendication 1 ou 2, dans lequel l'élément semi-conducteur (SW) est fixé à la carte métallique (11) par vissage.

4. Dispositif de conversion d'énergie électrique (10) selon l'une quelconque des revendications 1 à 3, comprenant en outre :
une carte de circuit connectée à la carte métallique (11) .

5. Dispositif de conversion d'énergie électrique (10) selon la revendication 4, dans lequel la carte de circuit entre en contact avec une surface latérale de la carte métallique (11) et est fixée à la partie métallique en utilisant un élément de fixation.

6. Appareil d'alimentation d'énergie électrique (100), comprenant le dispositif de conversion d'énergie électrique (10) selon l'une quelconque des revendications 1 à 5.
